# EUROPEAN PATENT APPLICATION

(11) **EP 2 595 317 A1**
(43) Date of publication of application: **22.05.2013**
(21) Application number: 11306507.2
(22) Date of filing: 17.11.2011
(51) Int. Cl.: H03K 17/0814, H03K 17/082

(54) **Method to apply a modulation controlling the state of a switch**

(71) Applicant: ST-Ericsson SA, 1228 Plan-les-Ouates (CH)
(72) Inventor: Oku, Kenichi, 06130 GRASSE (FR)
(74) Representative: Hirsch & Associés

(57) **Abstract**

A method to apply a modulation controlling the state of a switch (16) in a circuitry (10) for modulating the equivalent resistance of the switch (16) seen by the circuitry (10), so as to reduce the in-rush current created by switching on the switch (16) in the circuitry (10).

This enables to reduce the in-rush current produced by a switch while limiting the extra area involved.

## Description

### FIELD OF THE INVENTION

The invention relates to a method to apply a modulation controlling the state of a switch, a modulation circuitry, a set comprising a switch and the modulation circuitry, a circuitry package and a mobile phone adapted for carrying out the suggested use.

### BACKGROUND OF THE INVENTION

Complementary metal-oxide-semiconductor (also labeled after its acronym CMOS) is a technology for constructing integrated circuits. CMOS technology is used in microprocessors, microcontrollers, static RAM, and other digital logic circuits. CMOS technology is also used for several analog circuits such as image sensors, data converters, and highly integrated transceivers for many types of communication.

The field of CMOS process technology also addresses problems linked to the field of sub-micron technology. Thus, leakage current is very high compared to other technologies. Specific power switch implementations are widespread to overcome this leakage problem in the case of the low power applications in integrated circuits.

One physical problem taken into account in those implementations is the in-rush current appearing when enabling the power switch. In-rush current, input surge current or switch-on current refers to the maximum, instantaneous input current drawn by an electrical device when first turned on. The in-rush current depends notably on the capacitance of the switched domain. It is desirable to control this in-rush current.

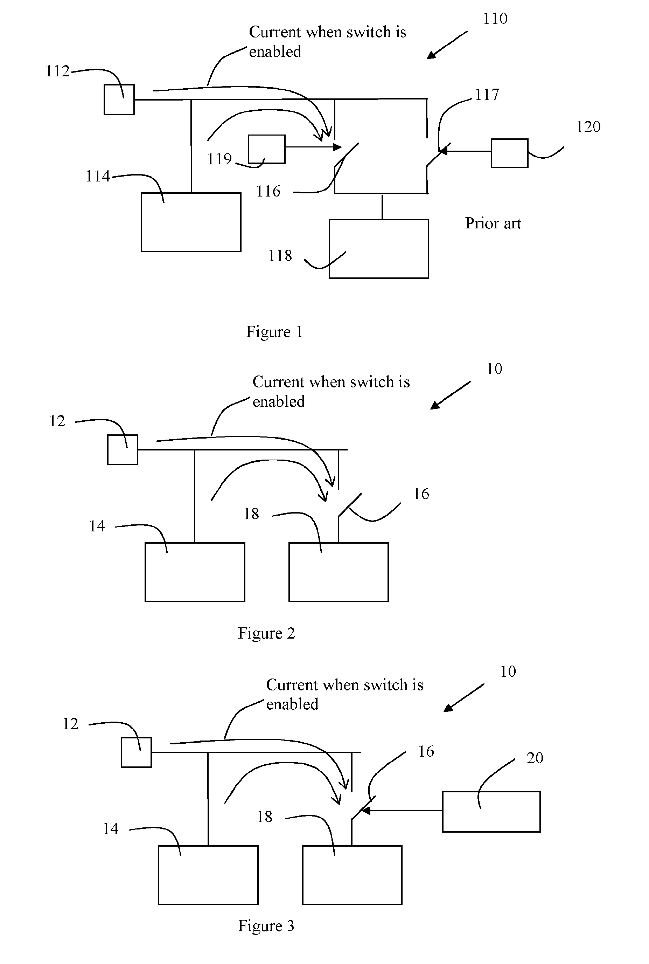

Several techniques exist to achieve this control. For instance, as illustrated in figure 1, it may be proposed a method wherein a relatively high impedance switch is first turned on and a relatively low impedance switch is then turned on. The circuitry 110 illustrated on Figure 1 comprises a supply pad 112 and the power domain 114 which is always fed up with power. Both supply pad 112 and power domain 114 are linked simultaneously to a high impedance switch 116 and to a low impedance switch 117. In the specific example of Figure 1, supply pad 112 and power domain 114 are in parallel with high impedance switch 16 and low impedance switch 117 which are respectively controlled by a first control circuit 119 and a second circuit 120. Such switch 116 and 117 are controlled to turn on one after another to provide power from the supply pad 112 and from power domain 114 to the zone 118 while avoiding in-rush current. Therefore, switch 116 and 117 can be labeled a power switch.

However, implementing such solution may need an additional switch, an additional control or a separate high impedance switch and low impedance switch. This results in area penalty.

Another solution may be to use an analog feedback loop to control the switch gate voltage to limit the peak current. The implementation of such loop implies an extra area for the analog control circuit. Indeed, analog circuit is generally a larger area than a digital implementation.

### SUMMARY OF THE INVENTION

The object of the present invention is to alleviate at least partly the above mentioned drawbacks.

More particularly, the invention aims to propose a solution to reduce the in-rush current produced by a switch while limiting the extra area involved.

This object is achieved with a method to apply a modulation controlling the state of a switch in a circuitry for modulating the equivalent resistance of the switch seen by the circuitry, so as to reduce the in-rush current created by switching on the switch in the circuitry.

Preferred embodiments comprise one or more of the following features:
● a duty cycle is defined for the modulation, the first duty cycle is inferior to the duty cycle reached at a predetermined time;
● a duty cycle is defined for the modulation, the first duty cycle is inferior to 10% and the duty cycle reached at a predetermined time is superior to 80%;
● a duty cycle is defined for the modulation, the duty cycle is increasing with time;
● the duty cycle increases from 1% to 100%, preferably 10% to 100%;
● an on-state is defined for the switch and during a first period, the switch remains in the on-state for less than 100 ns, preferably less than 10 nanoseconds, more preferably less than 1 ns;
● the in-rush current is tailored so as to reach a mean value different from 0;
● the in-rush current is tailored so as to reach a constant mean value different from 0;
● the mean value is determined based on the regime desired after application of the modulation;
● the mean value is determined based on a desired application;
● the modulation is a pulse-width modulation; and
● the mean value is determined based on the regime desired after application of the modulation.

It is also considered a modulation circuitry controlling the state of a switch in a circuitry for modulating the equivalent resistance of the switch seen by the circuitry so as to reduce the in-rush current created by switching on the switch in the circuitry, the modulation circuitry being adapted to produce a modulation for which a duty cycle is defined, the duty cycle increasing with time from 1% to 100%, preferably 10% to 100%.

The modulation circuitry may be adapted to carry out the method to apply as previously described.

It is further considered a set comprising a switch and a modulation circuitry being adapted to control the state of the switch in a circuitry for modulating the equivalent resistance of the switch seen by the circuitry so as to reduce the in-rush current created by switching on the switch in the circuitry.

The modulation circuitry in such set may be adapted to carry out the method to apply as previously described.

It is also considered a circuitry comprising such set and a mobile phone comprising the circuitry.

Further features and advantages of the invention will appear from the following description of embodiments of the invention, given as non-limiting examples, with reference to the accompanying drawings listed hereunder.

### BRIEF DESCRIPTION OF THE DRAWINGS

Figure 1 is a schematic view of basic implantation of a circuitry with two power switch as per previous art,
Figure 2 is a schematic view of a basic implementation of a circuitry with a power switch,
Figure 3 is a schematic view of an example of implementation of a circuitry with a power switch according to the invention,
Figure 4 represents the evolution of in-rush current with time in the circuitry of Figure 2,
Figure 5 represents the evolution of the modulation of the modulation circuitry, and
Figure 6 represents the evolution of in-rush current with time in the circuitry of Figure 4.

### DETAILED DESCRIPTION OF THE INVENTION

The invention is based on a study of the appearance of the in-rush current, and more specifically the parameters which have an influence on this phenomenon.

Figure 2 is a schematic view of a basic implementation of a circuitry with a power switch. The circuitry 10 illustrated on Figure 1 comprises a supply pad 12 and the power domain 14 which is always fed up with power. Both supply pad 12 and power domain 14 are linked to a switch 16. In the specific example of Figure 1, supply pad 12 and power domain 14 are in parallel with relation to switch 16. Such switch 16 enables to provide power from the supply pad 12 and from power domain 14 to the zone 18 to be provided with power. Therefore, switch 16 can be labeled a power switch. Switch 16 is enabled or disabled by a control circuit 19.

When switch 16 is turned on, an in-rush current will flow from supply pad 12 as well as the always on power domain 14. The evolution of such in-rush current with time is represented by the graph of Figure 2. The evolution is a decreasing exponential one with a peak current. Such peak current may be up to several A. 1A is considered for the value of peak current in the remainder of the description.

Such time evolution corresponds to the fact that the equivalent circuit of circuitry 10 of Figure 1 is a circuitry comprising a supply voltage submitted to a resistor and a capacitor placed in series. The capacitance of the equivalent capacitor can be deduced from the area of the zone 18 to be provided with power. The resistance of the equivalent resistor comes from the switch 16 size.

In other words, the peak current can be deduced from the area of the zone 18 to be provided with power, the supply voltage and the switch 16 size. The evolution of the decreasing exponential is linked to the inverse of the product of the capacitance by the resistance. Thus, the time evolution is run by the area of the zone 18 to be provided with power and the switch 16 size.

As the area of the zone 18 to be provided with power and the supply voltage depend on the circuitry 10 considered, it is suggested to modify the switch 16 size, at least the switch 16 size seen by circuitry 10.

To achieve this, it is proposed the method to apply a modulation controlling the state of the switch 16. By the expression "state", it should be understood that the switch 16 has at least two states, a state where zone 18 is provided with power and another state where zone 18 is not provided with power. Such modulation modulates the equivalent resistance of the switch 16 seen by circuitry 10, so as to reduce the in-rush current created by switching on switch 16 in circuitry 10.

A modulation of the state of switch 16 enables to switch on and switch off switch 16 alternatively. Therefore, compared to a case where switch 16 is only switched on once (for instance the case of Figure 1), the modulation proposed enables to modulate the equivalence resistance of switch 16 seen by circuitry 10. Indeed, when switch 16 is switched off, resistance of switch 16 seen by circuitry 10 is equal to infinity. Thus, when considering a mean value, the resistance of switch 16 is increased compared to the case where switch 16 is only switched on. This results in a reduced in-rush current created by switching on switch 16 in circuitry 10. This avoids the problem linked to a too large in-rush current. Notably, the always on domain 14 will not get lower voltage and the risk of its failure decreases since the risk of not enough supply voltage is greatly reduced.

Such use may be implemented in circuitry 10 represented on Figure 3. Such circuitry 10 comprises the elements of circuitry 10 of Figure 2 with a control circuit 20 substituted to the control circuit 19. The control circuit 20 is a modulation circuitry 20 comprising a modulation circuit 21 and adapted to control the state of switch 16 in circuitry 10 for modulating the equivalent resistance of the switch generated by the circuitry so as to reduce the in-rush current created by switching on switch 16 in circuitry 10.

The size of the modulation circuitry 20 is very reduced compared to the control circuitry of the switch 116 and 117 which has to be used in the case of Figure 1 (prior art). Indeed, only digital circuitry is required. The use proposed therefore enables to reduce the in-rush current produced by a switch while limiting the extra area involved.

The modulation employed in modulation circuitry 20 is preferably a modulation for which a duty cycle can be defined. In such case, the modulation can be divided in two states, an active state and an inactive state. The duty cycle is the ratio between the time spent by the modulation is in the active state and the total duration in time spent by the modulation is in both state (active and inactive). In other words, a low duty cycle (few percent for instance) corresponds to a low power because the modulation is mostly in the inactive state and a duty cycle of 100% corresponds to a case wherein the modulation is only in the active state.

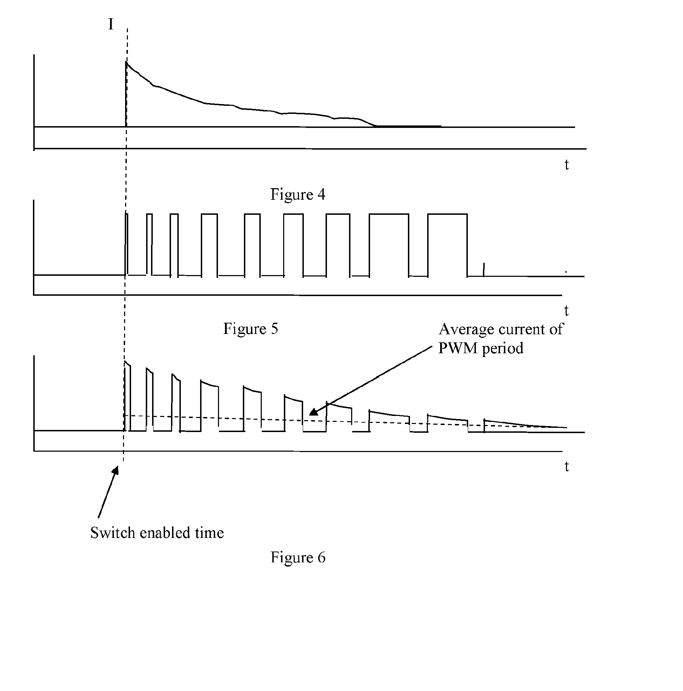

The modulation employed in modulation circuitry 20 is illustrated in Figure 5.

A pulse-width modulation (also named after its acronym PWM) is an example of modulation for which a duty cycle can be defined. A pulse-width modulation is also named a pulse-duration modulation (also named after its acronym PDM). Pulse-width modulation, as illustrated in Figure 5, uses a rectangular pulse wave whose pulse width is modulated resulting in the variation of the average of the waveform.

The pulse-width of the first pulse, noted W₁, is corresponding to a low percentage of the period of the signal. The pulse width of second pulse, noted W₂, is corresponding is corresponding to a low percentage of the period of the signal so that W₁ < W₂. In a more general approach, pulse-widths are defined so that Wᵢ < Wᵢ₊₁, where i varies between 1 (first pulse) to n, pulse-width Wₙ corresponding to a duty cycle of 100%.

Generating a pulse-width modulation can be made in a very easy way by the so-called "intersective method". According to this method, this can be carried out by using only sawtooth or a triangle waveform and a comparator. An oscillator is adapted to provide a sawtooth or a triangle waveform. In a more refined implementation, the characteristics of such pulse-width modulation are defined or optimized based on the equivalent capacitance and/or the equivalent resistance.

In case the modulation for which a duty cycle can be defined, the first duty cycle W₁ may be inferior to the duty cycle reached at a predetermined time Wₜ. This relation means that W₁ < Wₜ Indeed, the equivalent resistance of switch 16 seen by circuitry 10 during the first duty cycle is then inferior to the equivalent resistance of switch 16 seen by circuitry 10 at the predetermined time. This results in a reduced in-rush current.

Furthermore, the first duty cycle W₁ may be inferior to 10% and the duty cycle reached at a predetermined time Wₜ may be superior to 80%. Indeed, with such values, the reduction obtained in the in-rush current is greatly enhanced. Mathematically both relations are fulfilled if W₁ > 10% and Wₜ < 80%

So as to enable a monotonic evolution of the equivalent resistance, the duty cycle increases with time. For instance, the duty cycle may increases from 1% to 100%, preferably from 10% to 100%.

Moreover, the first period wherein the switch is in the on-state should be as short as possible. This enables to obtain a smooth evolution of the equivalent resistance of switch 16 seen by circuitry 10. As illustration, this first period lasts less than 100 ns, preferably less than 10 nanoseconds, more preferably less than 1 ns.

Figure 6 represents the evolutions with time of in-rush current in the circuitry 10 of Figure 3 and according to the modulation applied by modulation circuitry 20 (see Figure 5). The modulation corresponds to curve 22 whereas the in-rush current corresponds to curve 24. The modulation applied in this case is a PWM modulation whose duty cycle increases with time and represented in Figure 5. When comparing the resulting in-rush current obtained in the case of Figures 2 and 3, the in-rush current is greatly reduced as expected.

In-rush current is now sliced in pulses whose width is corresponding to respective width pulse modulation. For example, a first modulation pulse (W1) with a duty cycle of 10% will lead to an in-rush current of 10% length. In summary, the method to apply a modulation enables the in-rush current to be cut, while the mean value of the in-rush current is lowered.

In addition, according to the use illustrated by Figure 6, it appears that the in-rush current is tailored so as to reach a mean value different from 0 and represented as a dash line 26. This enables to obtain a substantially constant in-rush current which can be used for a dedicated purpose. Therefore, the mean value of the in-rush current may be determined based on a desired application. This can result in reduction in power consumption. For instance, mean values of the in-rush current may be equal to 100 mA or to 10 mA.

It is also proposed a modulation circuitry 20 controlling the state of the switch 16 in circuitry 10 for modulating the equivalent resistance of switch 16 seen by circuitry 10 so as to reduce the in-rush current created by switching on switch 16 in circuitry 10. Modulation circuitry 20 is adapted to produce a modulation for which a duty cycle is defined, the duty cycle increasing with time from 1% to 100%, preferably 10% to 100%. Such modulation circuitry 20 may be employed for controlling a switch and obtaining a reduced in-rush current with a limited area involved.

It is also proposed a set comprising such modulation circuitry 20 and a switch 16, the switch 16 being controlled by the modulation circuitry 20. Such set may be included in a circuitry, the circuitry being for instance a circuitry adapted to be included in a mobile phone.

The invention has been described with reference to preferred embodiments. However, many variations are possible within the scope of the invention.

## Claims

1. A method to apply a modulation controlling the state of a switch (16) in a circuitry (10) for modulating the equivalent resistance of the switch (16) seen by the circuitry (10), so as to reduce the in-rush current created by switching on the switch (16) in the circuitry (10).

2. A method according to claim 1, wherein a duty cycle is defined for the modulation, the first duty cycle is inferior to the duty cycle reached at a predetermined time.

3. A method according to claim 1 or claim 2, wherein a duty cycle is defined for the modulation, the first duty cycle is inferior to 10% and the duty cycle reached at a predetermined time is superior to 80%.

4. A method according to any one of claims 1 to 3, wherein a duty cycle is defined for the modulation, the duty cycle is increasing with time.

5. A method according to claim 4, wherein the duty cycle increases from 1% to 100%, preferably 10% to 100%.

6. A method according to any one of claims 1 to 5, wherein an on-state is defined for the switch (16) and wherein during a first period, the switch (16) remains in the on-state for less than 100 ns, preferably less than 10 nanoseconds, more preferably less than 1 ns.

7. A method according to any one of claims 1 to 6, wherein the in-rush current is tailored so as to reach a constant mean value different from 0.

8. A method according to claim 7, wherein the mean value is determined based on the regime desired after application of the modulation.

9. A method according to any one of claims 1 to 8, wherein the modulation is a pulse-width modulation.

10. A modulation circuitry (20) controlling the state of a switch (16) in a circuitry (10) for modulating the equivalent resistance of the switch (16) seen by the circuitry (10) so as to reduce the in-rush current created by switching on the switch (16) in the circuitry (10), the modulation circuitry (20) being adapted to produce a modulation for which a duty cycle is defined, the duty cycle increasing with time from 1% to 100%, preferably 10% to 100%.

11. A set comprising:
- a switch (16),
- a modulation circuitry (20) being adapted to control the state of the switch (16) in a circuitry (10) for modulating the equivalent resistance of the switch (16) seen by the circuitry (10) so as to reduce the in-rush current created by switching on the switch (16) in the circuitry (10).

12. A set according to claim 11, wherein the modulation circuitry (20) is adapted to carry out the method to apply according to any one of claims 2 to 10.

13. A circuitry comprising the set according to claim 11 or claim 12.

14. A mobile phone comprising the circuitry according to claim 13.
